# EUROPÄISCHE PATENTSCHRIFT

(11) **EP 2 924 396 B1**
(45) Veröffentlichungstag und Bekanntmachung des Hinweises auf die Patenterteilung: **31.05.2017**
(21) Anmeldenummer: 14199084.6
(22) Anmeldetag: 19.12.2014
(51) Int. Cl.: G01D 5/14, G01D 11/24, G01R 33/00, G01D 5/20

(54) **Abtastelement für eine induktive Winkelmesseinrichtung**
Scanning element for an inductive angle measuring device
Élément de palpage pour un dispositif de mesure d'angle inductif

(30) Priorität: 24.03.2014 DE 102014205397
(43) Veröffentlichungstag der Anmeldung: 30.09.2015
(73) Patentinhaber: Dr. Johannes Heidenhain GmbH, 83301 Traunreut (DE)
(72) Erfinder: Rosenegger, Gregor, 83278 Traunstein (DE)

(56) Entgegenhaltungen:
- EP-A2- 1 621 854
- US-A- 4 810 917
- US-A1- 2007 001 666

## Beschreibung

Die Erfindung betrifft ein Abtastelement für eine induktive Winkelmesseinrichtung zur Bestimmung von Relativpositionen gemäß dem Anspruch 1.

### GEBIET DER TECHNIK

Induktive Winkelmesseinrichtungen werden beispielsweise als Drehgeber zur Bestimmung der Winkellage zweier relativ zueinander drehbarer Maschinenteile verwendet. Bei induktiven Winkelmesseinrichtungen sind häufig Erregerleitungen und Empfängerleitungen etwa in Form von Leiterbahnen auf einer gemeinsamen Leiterplatte aufgebracht, die beispielsweise mit einem Stator eines Drehgebers fest verbunden ist. Dieser Leiterplatte gegenüber befindet sich ein Teilungselement, auf dem in periodischen Abständen alternierend elektrisch leitfähige und nichtleitfähige Flächen oder Stege und Lücken als Teilungsstruktur aufgebracht sind, und welches mit dem Rotor des Drehgebers drehfest verbunden ist. Wenn an den Erregerleitungen beziehungsweise Erregerspulen ein zeitlich wechselnder elektrischer Erregerstrom angelegt wird, werden in den Empfängerleitungen beziehungsweise - spulen während der Relativdrehung zwischen Rotor und Stator von der Winkellage abhängige Signale erzeugt. Diese Signale werden dann in einer Auswerteelektronik weiterverarbeitet.

Häufig werden derartige induktive Winkelmesseinrichtungen als Messgeräte für elektrische Antriebe, zur Bestimmung der Relativbewegung bzw. der Relativlage von entsprechenden Maschinenteilen, eingesetzt. In diesem Fall werden die erzeugten Positionswerte einer Folgeelektronik zur Ansteuerung der Antriebe über eine entsprechende Schnittstellenanordnung zugeführt.

### STAND DER TECHNIK

In der WO 2007/000653 A1 wird (beispielsweise gemäß der Figur 24 in jenem Dokument) eine induktive Winkelmesseinrichtung beschrieben, bei welcher der betreffende Sensor eine zylindrische Form aufweist.

In der Patentschrift US 4810917 ist eine Winkelmesseinrichtung gezeigt, welche eine gebogene Leiterplatte aufweist, wobei die Leiterplatte im Zuge der Montage der Winkelmesseinrichtung axial in ein Gehäuse eingebracht und dort vollständig vergossen wird.

### ZUSAMMENFASSUNG DER ERFINDUNG

Der Erfindung liegt die Aufgabe zugrunde ein Abtastelement für eine induktive Winkelmesseinrichtung zu schaffen, welches genaue Messsignale liefert und einfach zu montieren ist.

Diese Aufgabe wird erfindungsgemäß durch die Merkmale des Anspruches 1 gelöst.

Das Abtastelement für eine induktive Winkelmesseinrichtung umfasst eine Leiterplatte, welche Erregerleitungen und Empfängerleitungen aufweist, und eine elektronische Schaltung zur Verarbeitung von durch die Empfängerleitungen empfangenen Signale umfasst. Die Leiterplatte ist in einem Gehäuse angeordnet, wobei das Gehäuse eine Führung aufweist, in welche die Leiterplatte eingeführt ist. Die Führung ist so ausgestaltet, dass die Leiterplatte in einer Richtung parallel zu einer Achse formschlüssig positioniert ist. Weiterhin ist die Leiterplatte durch das Einführen in die Führung entlang einer Kreislinie, die um die Achse gekrümmt ist - insbesondere elastisch - verformt.

Das Abtastelement ist zur Abtastung eines Teilungselements geeignet, welches eine gekrümmte Mantelfläche aufweist, auf der zumindest eine Teilungsspur angeordnet ist. Die Winkelmesseinrichtung kann insbesondere so aufgebaut sein, dass das Gehäuse und das Teilungselement als zwei konzentrisch angeordnete Ringe ausgebildet sind. Der geometrische Mittelpunkt der Kreislinie, entlang welcher die Leiterplatte gekrümmt ist, liegt auf der Achse, um welche die Drehung im bestimmungsgemäßen Betrieb der Winkelmesseinrichtung erfolgen soll. Die Leiterplatte kann insbesondere als flexible Leiterplatte ausgestaltet sein. Mit Vorteil ist die Leiterplatte mehrlagig aufgebaut. Besonders vorteilhaft ist es, wenn die Leiterplatte Epoxy-Material umfasst. In vorteilhafter Ausgestaltung der Erfindung ist die Leiterplatte nicht dicker als 50 µm. Die Leiterplatte ist insbesondere einerseits steif genug ausgestaltet um durch die Verformung eine gleichmäßige kreisform anzunehmen und elastisch genug zum Einführen in die Führung. Zu beachten ist im vorliegenden Fall, dass eine genaue Einstellung des Luftspalts zwischen der Leiterplatte und dem radial gegenüber liegendem Teilungselement über den Messumfang hinweg für eine präzise Winkelmessung wichtig ist.

Das Gehäuse ist üblicherweise an derjenigen Seite offen, an welcher das Teilungselement beziehungsweise dessen Winkelstellung durch das Abtastelement abtastbar ist. Insbesondere ist bei einer Bauweise mit einem radial innen liegenden Teilungselement die radial innen liegende Seite des Gehäuses offen ausgestaltet, während bei einem radial außen liegenden Teilungselement die radial außen liegende Seite des Gehäuses offen ausgestaltet sein kann.

Mit Vorteil weist das Gehäuse eine Öffnung auf, die so ausgestaltet ist, dass die Leiterplatte im Zuge der Montage des Abtastelements in Tangentialrichtung in die Führung einführbar ist. Als Tangentialrichtung ist eine Richtung zu verstehen, die im Wesentlichen senkrecht zur Achse und im Wesentlichen senkrecht zur Radialrichtung verläuft. Insbesondere ist die Tangentialrichtung diejenige Richtung entlang welcher eine Winkelmessung erfolgen soll.

In weiterer Ausgestaltung der Erfindung ist die Leiterplatte derart im Gehäuse angeordnet, dass zwischen dem Gehäuse und der Leiterplatte ein Luftspalt vorliegt. Insbesondere liegt zwischen einem Bereich der Leiterplatte, in dem sich die Erregerleitungen und / oder Empfängerleitungen befinden und dem Gehäuse ein Luftspalt vor. Der Luftspalt erstreckt sich insbesondere in radialer Richtung.

Zudem kann die Leiterplatte derart im Gehäuse angeordnet sein, dass sich die Leiterplatte und das Gehäuse beziehungsweise die Führung an einem Rand der Leiterplatte berühren. Der Rand erstreckt sich insbesondere entlang der Längsseiten der Leiterplatte.

Mit Vorteil greift die Führung die Leiterplatte an zumindest einem Rand der Leiterplatte an. Mit anderen Worten wird die Leiterplatte in der Führung an zumindest einem Rand der Leiterplatte unmittelbar geführt. In vorteilhafter weise greift die Führung an zwei Rändern der Leiterplatte an.

Weiterhin kann die Führung als eine zumindest über einen Teilumfang des Gehäuses umlaufende Nut ausgestaltet sein. Die Führung kann insbesondere als zwei über einen Teilumfang des Gehäuses umlaufende Nuten ausgestaltet sein.

Gemäß einer bevorzugten Ausgestaltung der Erfindung ist die Leiterplatte über einen Winkel von 360° umlaufend angeordnet. Alternativ dazu kann die Leiterplatte auch über einen kleineren Winkel als 360° umlaufend angeordnet sein, so dass insbesondere das Abtastelement als ein Ringsegment ausgestaltet ist.

Mit Vorteil erstrecken sich die Empfängerleitungen und / oder die Erregerleitungen in Umfangsrichtung über einen Winkel von mehr als 180°, insbesondere von mehr als 225°, vorteilhaft mit einem Winkel von mindestens 270°. Die Winkelangaben beziehen sich auf einen Zentriwinkel mit einem Zentralpunkt auf derjenigen Achse, um welche die Drehung des Teilungselements relativ zum Abtastelement erfolgen soll.

Durch die vergleichsweise große Bogenlänge der Empfängerleitungen weisen die erzeugten Signale ein hohes Maß an Unempfindlichkeit gegen Exzentrizitäts- und Taumelfehler auf. In der Folge können relativ große Fertigungs- und Montagetoleranzen zugelassen werden.

In weiterer Ausgestaltung der Erfindung ist ein Ende der Leiterplatte radial außerhalb der Kreislinie, entlang welcher die Leiterplatte in der Führung platziert ist, angeordnet. Diese Bauweise kann dann Anwendung finden, wenn die Winkelmesseinrichtung so ausgestaltet ist, dass dieses ein radial innen liegendes Teilungselement aufweist.

Alternativ kann ein Ende der Leiterplatte radial innerhalb der Kreislinie, entlang welcher die Leiterplatte in der Führung platziert ist, angeordnet sein. Diese Bauweise wird vorzugsweise dann verwendet, wenn die Winkelmesseinrichtung so ausgestaltet ist, dass dieses ein radial außen liegendes Teilungselement aufweist.

Mit Vorteil ist die Leiterplatte derart angeordnet, dass eine von der Achse ausgehende radial orientierte Halbgerade die Leiterplatte an zumindest zwei Punkten schneidet. Die Leiterplatte weist also in diesem Fall eine nahezu um 360° entlang einer Kreisline verlaufende Form auf und nimmt dann darüber hinausgehend einen radial nach außen oder einen radial nach innen führenden Verlauf an.

Vorteilhafterweise ist die Leiterplatte an einem Ende mit einer Platine verbunden, auf der die elektronische Schaltung montiert ist, wobei die Halbgerade auch die Platine schneidet. Die elektronische Schaltung bildet insbesondere eine Auswerteelektronik zur Auswertung und Verarbeitung der von den der Empfängerleitungen erhaltenen Signale.

Insbesondere wenn die Leiterplatte über einen Winkel von 360° umlaufend angeordnet ist, ist es vorteilhaft, wenn die Leiterplatte an ihren Enden derart ausgestaltet ist, dass die beiden Enden in axialer Richtung überlappend anordenbar sind. Die Enden können beispielsweise zu diesem Zweck Ausnehmungen aufweisen. Insbesondere werden in diesem Fall beide Enden von einer Geraden, die parallel zur Achse verläuft geschnitten. Die Enden der Leiterplatte können insbesondere so ausgestaltet sein, dass dort weder Erregerleitungen noch Empfängerleitungen vorliegen.

Die Leiterplatte kann mehrteilig aufgebaut sein, wobei dann die Teile der Leiterplatte durch ein Überbrückungsstück miteinander verbunden sein können.

Mit Vorteil weist das Überbrückungsstück in einer Richtung parallel zur Achse eine geringere Ausdehnung auf als die Leiterplatte. Die Leiterplatte ist also insbesondere breiter als das Überbrückungsstück.

In weiterer Ausgestaltung der Erfindung sind die Teile der mehrteilig aufgebauten Leiterplatte mit einem Spalt in Umfangsrichtung voneinander beabstandet angeordnet. Dies hat insbesondere den Vorteil, dass beim Fügen der Teile der Leiterplatte eine präzise und einfache Platzierung der Teile zueinander und damit der Empfängerleitungen zueinander möglich ist. Dies ist für die Erreichung präziser Messwerte vorteilhaft.

Das Gehäuse kann ein Gehäuseteil aufweisen, welches mit Hilfe einer Hinterschneidung, die in einer Richtung parallel zur Achse verläuft, am Gehäuse festgelegt ist. Als Hinterschneidung kann im Folgenden eine Ausnehmung verstanden werden, die einen Formschluss ermöglicht, insbesondere zum formschlüssigen Übertragen von radial gerichteten Kräften.

Vorteilhafte Ausbildungen der Erfindung entnimmt man den abhängigen Ansprüchen.

Weitere Einzelheiten und Vorteile des erfindungsgemäßen Abtastelements ergeben sich aus der nachfolgenden Beschreibung eines Ausführungsbeispiels anhand der beiliegenden Figuren.

### KURZE BESCHREIBUNG DER ZEICHNUNGEN

Es zeigen die
- Figur 1: eine perspektivische Ansicht einer Winkelmesseinrichtung zur Bestimmung einer relativen Winkelposition,
- Figur 2: eine perspektivische Ansicht eines Teilbereichs eines Gehäuses,
- Figur 3: eine Draufsicht auf eine Leiterplatte vor der Montage,
- Figur 4: eine Seitenansicht auf die Leiterplatte vor der Montage,
- Figur 5: eine Draufsicht auf einen Teilbereich der Leiterplatte vor der Montage,
- Figur 6: eine perspektivische Ansicht eines Teilbereichs des Gehäuses mit montierter Leiterplatte,
- Figur 7: eine weitere perspektivische Ansicht eines Teilbereichs des Gehäuses mit montierter Leiterplatte,
- Figur 8: eine Seitenansicht auf einen Teilbereich des Abtastelements einer Winkelmesseinrichtung nach der Montage eines weiteren Gehäuseteils,
- Figur 9: eine Schnittdarstellung auf einen Teilbereich des Abtastelements.

### BESCHREIBUNG DER AUSFÜHRUNGSFORMEN

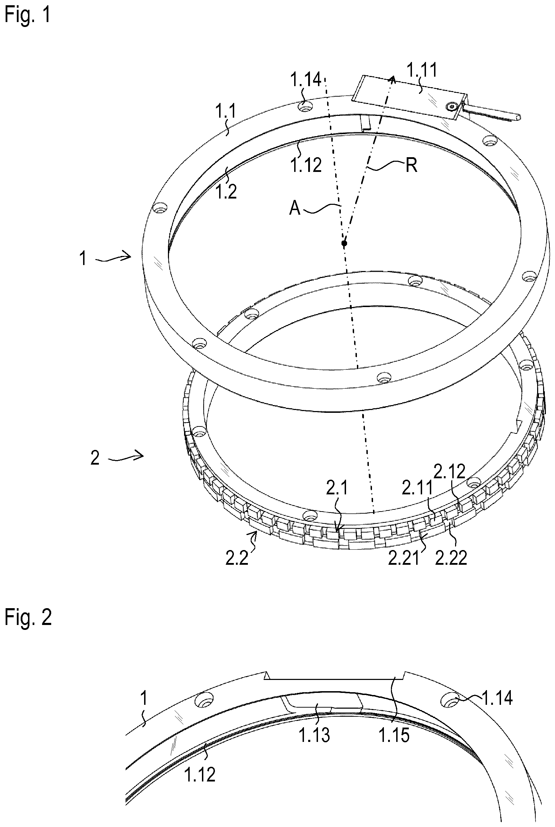

In der Figur 1 ist eine Winkelmesseinrichtung gezeigt, die ein Abtastelement 1 und ein Teilungselement 2 aufweist, wobei das Teilungselement 2 relativ zum Abtastelement 1 um eine Achse A drehbar angeordnet ist. In der Figur 1 sind das Abtastelement 1 und das Teilungselement 2 zum Zwecke der Erläuterung der Bauweise separat dargestellt. Im betriebsgemäßen Zustand liegen das Abtastelement 1 und das Teilungselement 2 mit radialem Luftspalt konzentrisch einander gegenüber. Das Abtastelement 1 umfasst ein Gehäuse 1.1, das im vorgestellten Ausführungsbeispiel ein Gehäuseteil 1.11 aufweist und hier im Wesentlichen ringförmig ausgestaltet ist. Insbesondere ist bei der im vorgestellten Ausführungsbeispiel gezeigten Bauweise mit einem radial innen liegenden Teilungselement die radial innen liegende Seite des Gehäuses offen ausgestaltet.

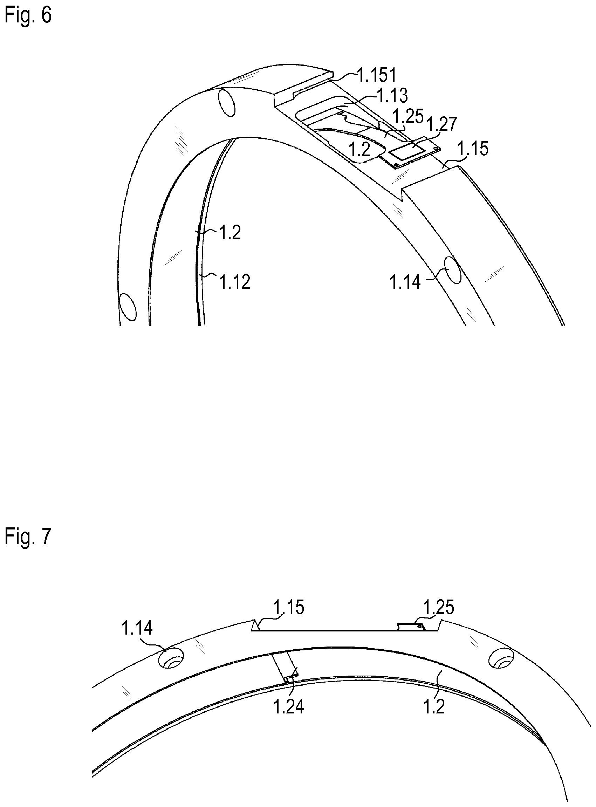

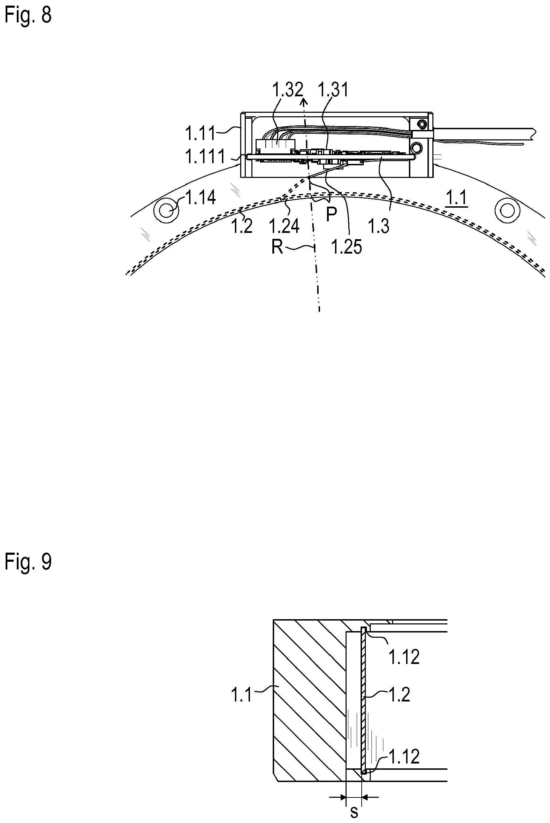

In der Figur 2 ist das Gehäuse 1.1 ohne das Gehäuseteil 1.11 in einer Teilansicht perspektivisch dargestellt. Das Gehäuse 1.1 weist eine Führung 1.12 auf, die im vorgestellten Ausführungsbeispiel so ausgestaltet ist, dass diese nahezu über den gesamten Umfang entlang einer Kreislinie umläuft. Die Führung 1.12 weist hier zwei umlaufende Nuten (siehe auch die Figur 9) auf. Weiterhin weist das Gehäuse 1.1 eine Öffnung 1.13 auf. Mit Hilfe von Befestigungsbohrungen 1.14 kann das Gehäuse 1.1 an einem Maschinenteil festgelegt werden. Zur Aufnahme des Gehäuseteils 1.11 weist das Gehäuse 1.1 eine Ausnehmung 1.15 (siehe auch die Figur 6) auf, an deren in Umfangsrichtung begrenzenden Absätzen Hinterschneidungen 1.151 beziehungsweise Nuten eingearbeitet sind.

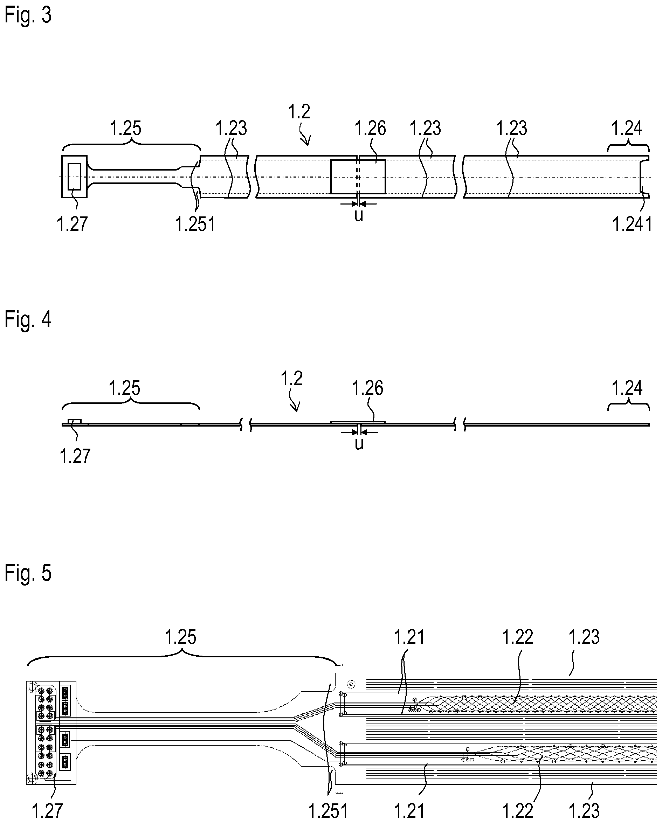

In den Figuren 3 bis 5 ist eine Leiterplatte 1.2 dargestellt bevor diese in dem Gehäuse 1.1 montiert wird. In der Figur 3 ist eine Draufsicht auf die Leiterplatte 1.2 insbesondere zur Erläuterung der geometrischen Kontur der Leiterplatte 1.2 gezeigt. Die Leiterplatte 1.2 weist einen mehrlagigen Aufbau auf und hat hier eine Dicke von 0,5 mm. Im vorgestellten Ausführungsbeispiel ist die Leiterplatte 1.2 zweiteilig aufgebaut. Die beiden Teile der Leiterplatte 1.2 sind mechanisch und elektrisch durch ein Überbrückungsstück 1.26 in Form eines Leiterplattenstücks miteinander verbunden. Die Teile der Leiterplatte 1.2 sind mit einem Spalt u voneinander beabstandet angeordnet. Der Spalt u erstreckt sich in Längsrichtung der Leiterplatte 1.2, nach erfolgter Montage im Gehäuse 1.1 also in Umfangsrichtung beziehungsweise in Messrichtung. Das Überbrückungsstück 1.26 hat eine geringere Breite als die Leiterplatte 1.2. Bevor die beiden Teile der Leiterplatte 1.2 durch das Überbrückungsstück 1.26 endgültig verbunden werden, werden die Teile derart zueinander ausgerichtet, dass die Empfängerleitungen 1.22, die auf beiden Teilen angeordnet sind, exakt zueinander platziert sind. Erst danach wird die Verbindung endgültig hergestellt.

Dem Spalt u jeweils gegenüber liegend weist die Leiterplatte 1.2 zwei Enden 1.24, 1.25 auf. Das erste Ende 1.24 umfasst eine Ausnehmung 1.241. Das zweite Ende 1.25 weist zwei Ausnehmungen 1.251 auf, sowie ein elektrisches Anschlussstück 1.27. In der Figur 5 ist das zweite Ende 1.25 mit dem daran anschließenden Bereich der Leiterplatte 1.2 gezeigt. Demnach umfasst die Leiterplatte 1.2 Erregerleitungen 1.21 und Empfängerleitungen 1.22, wobei den Empfängerleitungen 1.22 im vorgestellten Ausführungsbeispiel zwei Spuren zugeordnet sind. Die Erregerleitungen 1.21 und die Empfängerleitungen 1.22 sind als Leiterbahnen auf der als mehrlagig aufgebauten flexiblen Leiterplatte 1.2 ausgestaltet. Die erste und die zweite Spur der Empfängerleitungen 1.22 weisen jeweils ein Paar Empfängerleiterbahnen auf. Wie aus der Figur 5 ersichtlich, ist demzufolge sowohl neben der ersten als auch neben der zweiten Spur zu beiden Seiten eine Erregerleitung 1.21 angeordnet.

Im Bereich des zweiten Endes 1.25 sind weder Erregerleitungen 1.21 noch Empfängerleitungen 1.22 angeordnet. Vielmehr befinden sich im Bereich des zweiten Endes 1.25 Leiterbahnen für die Versorgung der Erregerleitungen 1.21 und zur Ableitung der von den Empfängerleitungen 1.22 empfangen Signale zum Anschlussstück 1.27.

Im Übrigen sind auch im Bereich des ersten Endes 1.24, welches nicht im Detail in den Figuren dargestellt ist, weder Erregerleitungen 1.21 noch Empfängerleitungen 1.22. Genauso weisen Ränder 1.23, die sich entlang der Längskanten der Leiterplatte 1.2 erstrecken, keine Erregerleitungen 1.21 und keine Empfängerleitungen 1.22 auf.

Die Figur 4 zeigt die Leiterplatte 1.2 in einer Seitenansicht. Daraus ist ersichtlich, dass die Leiterplatte 1.2 vor der Montage in das Gehäuse 1.1 eine ebene Form aufweist.

Mit Hilfe eines Lötverfahrens, beispielsweise eines Bügellötverfahrens, wird eine Platine 1.3 mit dem Anschlussstück 1.27 der Leiterplatte 1.2 verbunden. In der Figur 8 ist eine entsprechende Anordnung gezeigt. Die Platine 1.3 ist mit elektronischen Bausteinen bestückt, die eine elektronische Schaltung 1.31 bilden. Weiterhin ist auf der Platine 1.3 ein Steckerelement 1.32 angeordnet. Über ein Kabel ist die elektronische Schaltung 1.31 und somit das Abtastelement 1 mit einer Folgeelektronik verbindbar.

Üblicherweise wird die Platine 1.3 mit der Leiterplatte 1.2 verbunden, bevor die Leiterplatte 1.2 im Gehäuse 1.1 platziert wird. Der Übersichtlichkeit halber wird jedoch in den Figuren 6 und 7 auf die Darstellung der Platine 1.3 verzichtet um die Montageschritte besser erläutern zu können. Im Zuge der Montage des Abtastelements 1 wird die Leiterplatte 1.2 durch die Öffnung 1.13 in Tangentialrichtung in die Führung 1.2 gesteckt und in diese vollständig eingeführt beziehungsweise eingeschoben bis das erste Ende 1.24 der Leiterplatte 1.2 die Oberfläche der Leiterplatte 1.2 berührt. Die als zwei Nuten ausgestaltete Führung 1.2 umgreift dabei die Ränder 1.23 der Leiterplatte 1.2. Zudem wird die Leiterplatte 1.2 stirnseitig im Bereich der Ränder 1.23 mit Hilfe der Nuten geführt, so dass die Leiterplatte 1.2 in einer Richtung parallel zur Achse A formschlüssig positioniert ist. Die Führung 1.12 beziehungsweise die Nuten ist / sind so dimensioniert, dass ein Einschieben der Leiterplatte 1.2 möglich ist und dennoch eine exakte Positionierung der Leiterplatte 1.2 im Gehäuse 1.1 erreicht wird. Hinzu kommt, dass durch die elastische Verformung der Leiterplatte 1.2 eine mechanische Spannung entsteht, welche die Leiterplatte 1.2 gegen die radial außen liegenden Wände der Nuten der Führung 1.12 drängt. Auf diese Weise kann trotz des unerlässlichen Spiels zwischen der Leiterplatte 1.2 und der Führung 1.12 eine für die erforderliche Messgenauigkeit präzise Positionierung der Leiterplatte 1.2 entlang ihrer Längserstreckung hinweg erzielt werden.

Wie bereits oben dargelegt, ist in der Montagephase gemäß den Figuren 6 und 7 üblicherweise die Platine 1.3 bereits mit dem ersten Ende 1.24 der Leiterplatte 1.2 verbunden. Alternativ könnte auch in der in den Figuren 6 und 7 gezeigten Phase die Platine 1.3 mit Leiterplatte 1.2 verbunden sein.

Als Nächstes wird nun das Gehäuseteil 1.11 parallel zur Richtung der Achse A in die Nuten 1.151 eingeschoben, Gleichzeitig wird die Platine 1.3 von ebenfalls achsparallelen Nuten 1.111 des Gehäuseteils 1.11 aufgenommen. Nach diesem Montageschritt liegt eine Anordnung gemäß der Figur 8 vor. Danach wird das Gehäuseteil 1.11 mit einem Deckel verschlossen. Zur Erreichung einer erhöhten Dichtigkeit können Klebe- oder Vergussmittel vor oder nach dem Montieren des Gehäuseteils 1.11 in die Fugen und / oder Hohlräume eingebracht werden.

Durch das Einführen in die Führung 1.12 ist die Leiterplatte 1.2 entlang einer Kreislinie, die um die Achse A gekrümmt ist, elastisch verformt. Im Bereich der Führung 1.12 nimmt also die Leiterplatte 1.2 eine ringförmige beziehungsweise hohlzylindrische Form an, wobei die Leiterplatte 1.2 länger ist als die Führung 1.12 und insbesondere länger als der für die reine Abtastung des Teilungselement 2 erforderliche Umfang. Der über diese Länge hinausgehende Teil der Leiterplatte 1.2, insbesondere das zweite Ende 1.25 verläuft mit einer radial nach außen gerichteten Richtungskomponente, wie beispielsweise in der Figur 8 dargestellt. Somit weist das Abtastelement 1 einen Bereich auf, innerhalb welchem eine von der Achse A ausgehende radial orientierte Halbgerade R die Leiterplatte 1.2 zweimal schneidet (die Schnittpunkte sind in der Figur 8 mit P bezeichnet). Die Leiterplatte 1.2 ist insofern im montierten Zustand mit einem überlappenden Ende 1.24 angeordnet, wobei das Ende 1.24 radial außerhalb in Bezug auf die Kreislinie angeordnet ist.

Das fertig montierte Abtastelement 1 weist demnach eine ringförmig im Gehäuse 1.1 angeordnete flexible Leiterplatte 1.2 auf, auf welcher die Erregerleitungen 1.21 und die Empfängerleitungen 1.22 angeordnet sind. Sowohl die Erregerleitungen 1.21 als auch die Empfängerleitungen 1.22 weisen eine Erstreckung entlang der Umfangsrichtung auf und zwar nahezu über den gesamten Umfang des Abtastelements 1. Eine vollständige Erstreckung über den gesamten Umfang ist in der Praxis kaum oder nur mit erhöhtem Aufwand herstellbar, weil auf dem Abtastelement 1 Anschlussbereiche für die Erregerleitungen 1.21 und Empfängerleitungen 1.22 vorgesehen sind, was eine - wenn auch nur geringfügige - Diskontinuität zur Folge hat.

Im betriebsgemäßen Zustand liegt das Teilungselement 2 radial innerhalb des Abtastelements 1, ohne dass sich diese berühren. Üblicherweise dient das Teilungselement 2 als Rotor und wird an einem um eine Achse A drehbaren Maschinenteil befestigt. Dagegen bildet dann das Abtastelement 1 den Stator der Winkelmesseinrichtung, so dass dieses an einem stehenden Maschinenteil fixiert wird. Bei einer Relativdrehung zwischen Teilungselement 2 und Abtastelement 1 um die Achse A ist im Abtastelement 1 ein von der jeweiligen Winkelstellung abhängiges Signal durch Induktionseffekte erzeugbar. Eine mit dem erfindungsgemäßen Abtastelement 1 ausgestattete Winkelmesseinrichtung dient demnach zur Erfassung einer Winkelposition zwischen dem Abtastelement 1, das an einem ersten Maschinenteil festlegbar ist und dem Teilungselement 2, das an einem zweiten Maschinenteil, etwa einer Welle, festlegbar ist.

Das Teilungselement 2 ist in diesem Ausführungsbeispiel als ein Ring ausgestaltet, an dessen Mantelseite sich zwei mit axialem Abstand angeordnete Teilungsspuren 2.1, 2.2 befinden. Die Teilungsspuren 2.1, 2.2 umfassen im vorgestellten Beispiel Stege 2.11, 2.21 und dazwischen liegende Lücken 2.12, 2.22, wobei die erste Teilungsspur 2.1 vierundsechzig derartiger Stege 2.11 aufweist, während die zweite Teilungsspur 2.2 nur einunddreißig Stege 2.22 umfasst. Die beiden Teilungsspuren 2.1, 2.2 bestehen folglich jeweils aus einer periodischen Abfolge von alternierend angeordneten Stegen 2.11, 2.21 und Lücken 2.12, 2.22. Die Teilungsspuren 2.1, 2.2 weisen insbesondere entlang der Umfangsrichtung unterschiedliche Teilungsperioden.

Voraussetzung für die Bildung von entsprechenden Signalen ist, dass die Erregerleitungen 1.21 ein zeitlich wechselndes elektromagnetisches Erregerfeld im Bereich der Empfängerleitungen 1.22 bzw. im Bereich der damit abgetasteten Teilungsspuren 2.1, 2.2 erzeugen. Im dargestellten Ausführungsbeispiel sind die Erregerleitungen 1.21 als mehrere parallele, Stromdurchflossene Einzel-Leiterbahnen ausgebildet. Werden die Erregerleitungen 1.21 bestromt, so bildet sich um die jeweilige Erregerleitung 1.21 ein schlauch- bzw. zylinderförmig orientiertes elektromagnetisches Feld aus. Die Feldlinien des resultierenden elektromagnetischen Feldes verlaufen in Form konzentrischer Kreise um die Erregerleitungen 1.21, wobei die Richtung der Feldlinien in bekannter Art und Weise von der Stromrichtung in den Erregerleitungen 1.21 abhängt. Im Bereich der Stege 2.11, 2.21 werden Wirbelströme induziert, so dass eine von der Winkelstellung abhängige Modulation des Feldes erreicht wird. Entsprechend kann durch die Empfängerleitungen 1.22 die Relativposition in Umfangsrichtung gemessen werden. Die Paare von Empfängerleitungen 1.22 einer Empfängerspur sind so angeordnet, dass diese jeweils um 90° phasenversetzte Signale liefern, so dass auch eine Bestimmung der Drehrichtung vorgenommen werden kann. Jede der Empfängerspuren zur Bestimmung der Position in Umfangsrichtung, also der Winkelstellung, wird von einer eigenen Erregerleitung 1.21 umgeben. Die elektronische Schaltung 1.31 auf der Platine 1.3 dient zur Auswertung beziehungsweise Verarbeitung der Signale, so dass beispielsweise digitale Daten, welche die Information über die gemessene Winkelposition beinhalten, gebildet und ausgegeben werden.

Die beiden Spuren der Empfängerleitungen 1.22 erstrecken sich praktisch um den gesamten Umfang des Abtastelements 1 also um fast 360° um die Achse A. Durch diese Bauweise kann auch bei vergleichsweise großen Anbautoleranzen eine genaue Winkelbestimmung erreicht werden.

Dadurch, dass die zwei Teilungsspuren 2.1, 2.2 geringfügig unterschiedliche Teilungsperioden aufweisen, kann aus den Signalen der Empfängerleitungen 1.22 unter Nutzung des Schwebungs- bzw. Noniusprinzips die absolute Winkelstellung des Teilungselements 2 in Bezug auf das Abtastelement 1 bestimmt werden.

## Patentansprüche

1. Abtastelement (1) für eine induktive Winkelmesseinrichtung, wobei das Abtastelement (1)
- eine Leiterplatte (1 2), welche Erregerleitungen (1.21) und Empfängerleitungen (1.22) aufweist, und
- eine elektronische Schaltung (1.31)
umfasst, wobei
die Leiterplatte (1.2) in einem Gehäuse (1.1) angeordnet ist,
**dadurch gekennzeichnet, dass**
das Gehäuse (1.1) eine Führung (1.12) aufweist, in welche die Leiterplatte (1.2) eingeführt ist, wobei die Führung (1.12) so ausgestaltet ist, dass die Leiterplatte (1.2) in einer Richtung parallel zu einer Achse (A) formschlüssig positioniert ist und die Leiterplatte (1.2) durch das Einführen in die Führung (1.12) entlang einer Kreislinie, die um die Achse (A) gekrümmt ist, verformt ist.

2. Abtastelement (1) gemäß dem Anspruch 1, **dadurch gekennzeichnet, dass** das Gehäuse (1.1) eine Öffnung (1.13) aufweist, die so ausgestaltet ist, dass die Leiterplatte (1.2) in Tangentialrichtung in die Führung (1.12) einführbar ist.

3. Abtastelement (1) gemäß dem Anspruch 1 oder 2, **dadurch gekennzeichnet, dass** die Leiterplatte (1.2) derart im Gehäuse (1.1) angeordnet ist, dass zwischen dem Gehäuse (1.1) und der Leiterplatte (1.2) ein Luftspalt (s) vorliegt.

4. Abtastelement (1) gemäß einem der vorhergehenden Ansprüche, **dadurch gekennzeichnet, dass** die Leiterplatte (1.2) derart im Gehäuse (1.1) angeordnet ist, dass sich die Leiterplatte (1.2) und das Gehäuse (1.1) an einem Rand (1.23) der Leiterplatte (1.2) berühren.

5. Abtastelement (1) gemäß einem der vorhergehenden Ansprüche, **dadurch gekennzeichnet, dass** die Führung (1.12) die Leiterplatte (1.2) an zumindest einem Rand (1.23) der Leiterplatte (1.2) angreift.

6. Abtastelement (1) gemäß einem der vorhergehenden Ansprüche, **dadurch gekennzeichnet, dass** die Führung (1.12) als eine zumindest über einen Teilumfang umlaufende Nut ausgestaltet ist.

7. Abtastelement (1) gemäß einem der vorhergehenden Ansprüche, **dadurch gekennzeichnet, dass** die Leiterplatte (1.2) über einen Winkel von 360° umlaufend angeordnet ist.

8. Abtastelement (1) gemäß einem der vorhergehenden Ansprüche, **dadurch gekennzeichnet, dass** ein Ende (1.25) der Leiterplatte (1.2) radial außerhalb oder radial innerhalb der Kreislinie angeordnet ist.

9. Abtastelement (1) gemäß einem der vorhergehenden Ansprüche, **dadurch gekennzeichnet, dass** die Leiterplatte (1.2) derart angeordnet ist, dass eine von der Achse (A) ausgehende radial orientierte Halbgerade (R) die Leiterplatte (1.2) an zumindest zwei Punkten (P) schneidet.

10. Abtastelement (1) gemäß dem Anspruch 9, **dadurch gekennzeichnet, dass** die Leiterplatte (1.2) an einem Ende (1.25) mit einer Platine (1.3) verbunden ist, auf der die elektronische Schaltung (1.31) montiert ist, wobei die Halbgerade (R) auch die Platine (1.3) schneidet.

11. Abtastelement (1) gemäß einem der vorhergehenden Ansprüche, **dadurch gekennzeichnet, dass** die Leiterplatte (1.2) an ihren Enden (1.24, 1.25) derart ausgestaltet ist, dass die beiden Enden (1.24, 1.25) in axialer Richtung überlappend anordenbar sind.

12. Abtastelement (1) gemäß einem der vorhergehenden Ansprüche, **dadurch gekennzeichnet, dass** die Leiterplatte (1.2) mehrteilig aufgebaut ist und die Teile der Leiterplatte (1.2) durch ein Überbrückungsstück (1.26) miteinander verbunden sind.

13. Abtastelement (1) gemäß dem Anspruch 12, **dadurch gekennzeichnet, dass** das Überbrückungsstück (1.26) in einer Richtung parallel zur Achse (A) eine geringere Ausdehnung aufweist als die Leiterplatte (1.2).

14. Abtastelement (1) gemäß einem der vorhergehenden Ansprüche, **dadurch gekennzeichnet, dass** die Leiterplatte (1.2) mehrteilig aufgebaut ist und die Teile der Leiterplatte (1.2) mit einem Spalt (u) in Umfangsrichtung voneinander beabstandet angeordnet sind.

15. Abtastelement (1) gemäß einem der vorhergehenden Ansprüche, **dadurch gekennzeichnet, dass** das Gehäuse (1.1) ein Gehäuseteil (1.11) aufweist, welches mit Hilfe einer Hinterschneidung (1.151), die in einer Richtung parallel zur Achse (A) verläuft, am Gehäuse (1.1) festgelegt ist.

## Claims

1. Scanning element (1) for an inductive angle measuring device, the scanning element (1) comprising
- a printed circuit board (1.2), which has excitation lines (1.21) and receiver lines (1.22), and
- an electronic circuit (1.31),
the printed circuit board (1.2) being arranged in a housing (1.1),
**characterized in that**
the housing (1.1) has a guide (1.12) into which the printed circuit board (1.2) is inserted, wherein the guide (1.12) is configured in such a way that the printed circuit board (1.2) is positioned with a form fit in a direction parallel to an axis (A), and the printed circuit board (1.2) is deformed by the insertion into the guide (1.12) along a circular line which is curved about the axis (A).

2. Scanning element (1) according to Claim 1, **characterized in that** the housing (1.1) has an opening (1.13), which is configured such that the printed circuit board (1.2) can be inserted into the guide (1.12) in the tangential direction.

3. Scanning element (1) according to Claim 1 or 2, **characterized in that** the printed circuit board (1.2) is arranged in the housing (1.1) in such a way that there is an air gap (s) between the housing (1.1) and the printed circuit board (1.2).

4. Scanning element (1) according to one of the preceding claims, **characterized in that** the printed circuit board (1.2) is arranged in the housing (1.1) in such a way that the printed circuit board (1.2) and the housing (1.1) touch at an edge (1.23) of the printed circuit board (1.2).

5. Scanning element (1) according to one of the preceding claims, **characterized in that** the guide (1.12) acts on the printed circuit board (1.2) on at least one edge (1.23) of the printed circuit board (1.2).

6. Scanning element (1) according to one of the preceding claims, **characterized in that** the guide (1.12) is configured as a circumferential groove, at least over a part of the circumference.

7. Scanning element (1) according to one of the preceding claims, **characterized in that** the printed circuit board (1.2) is arranged so as to run around over an angle of 360°.

8. Scanning element (1) according to one of the preceding claims, **characterized in that** one end (1.25) of the printed circuit board (1.2) is arranged radially outside or radially inside the circular line.

9. Scanning element (1) according to one of the preceding claims, **characterized in that** the printed circuit board (1.2) is arranged in such a way that a radially oriented radius (R) originating from the axis (A) intersects the printed circuit board (1.2) at at least two points (P).

10. Scanning element (1) according to Claim 9, **characterized in that** the printed circuit board (1.2) is connected at one end (1.25) to a circuit board (1.3) on which the electronic circuit (1.31) is mounted, wherein the radius (R) also intersects the circuit board (1.3).

11. scanning element (1) according to one of the preceding claims, **characterized in that** the printed circuit board (1.2) is configured at its ends (1.24, 1-25) in such a way that the two ends (1.24, 1.25) can be arranged to overlap in the axial direction.

12. Scanning element (1) according to one of the preceding claims, **characterized in that** the printed circuit board (1.2) is built up from several parts and the parts of the printed circuit board (1.2) are connected to each other via a bridging piece (1.26).

13. Scanning element (1) according to Claim 12, **characterized in that** the bridging piece (1.26) has a lesser extent in a direction parallel to the axis (A) than the printed circuit board (1.2).

14. Scanning element (1) according to one of the preceding claims, **characterized in that** the printed circuit board (1.2) is built up from several parts and the parts of the printed circuit board (1.2) are arranged spaced apart from one another with a gap (u) in the circumferential direction.

15. Scanning element (1) according to one of the preceding claims, **characterized in that** the housing (1.1) has a housing part (1.11) which is fixed to the housing (1.1) with the aid of an undercut (1.151) which extends in a direction parallel to the axis (A).

## Revendications

1. Elément de balayage (1) destiné à un dispositif de mesure d'angle à induction, dans lequel l'élément de balayage (1) comprend
- une carte de circuit imprimé (1.2) qui comporte des conducteurs d'excitation (1.21) et des lignes de réception (1.22), et
- un circuit électronique (1.31), dans lequel la carte de circuit imprimé (1.2) est disposée dans un boîtier (1.1),
**caractérisé en ce que** le boîtier (1.1) comporte un guide (1.12) dans lequel est introduite la carte de circuit imprimé (1.2), dans lequel le guide (1.12) est conçu de manière à ce que la carte de circuit imprimé (1.2) soit positionnée par complémentarité de forme dans une direction parallèle à un axe (A) et à ce que la carte de circuit imprimé (1.2) soit déformée par l'introduction dans le guide (1.12) le long d'une ligne circulaire qui est incurvée autour de l'axe (A).

2. Elément de balayage (1) selon la revendication 1, **caractérisé en ce que** le boîtier (1.1) comporte une ouverture (1.13) qui est conçue de manière à ce que la carte de circuit imprimé (1.2) puisse être insérée en direction tangentielle dans le guide (1.12).

3. Elément de balayage (1) selon la revendication 1 ou 2, **caractérisé en ce que** la carte de circuit imprimé (1.2) est disposée dans le boîtier (1.1) de manière à ce qu'un entrefer (s) soit présent entre le boîtier (1.1) et la carte de circuit imprimé (1.2).

4. Elément de balayage (1) selon l'une quelconque des revendications précédentes, **caractérisé en ce que** la carte de circuit imprimé (1.2) est disposée dans le boîtier (1.1) de manière à ce que la carte de circuit imprimé (1.2) et le boîtier (1.1) soient en contact l'un avec l'autre sur un bord (1.23) de la carte de circuit imprimé (1.2).

5. Elément de balayage (1) selon l'une quelconque des revendications précédentes, **caractérisé en ce que** le guide (1.12) s'engage sur la carte de circuit imprimé (1.2) sur au moins un bord (1.23) de la carte de circuit imprimé (1.2).

6. Elément de balayage (1) selon l'une quelconque des revendications précédentes, **caractérisé en ce que** le guide (1.12) est conçu sous la forme d'une rainure circonférentielle sur au moins une partie de la périphérie.

7. Elément de balayage (1) selon l'une quelconque des revendications précédentes, **caractérisé en ce que** la carte de circuit imprimé (1.2) est disposée circonférentiellement sur un angle de 360°.

8. Elément de balayage (1) selon l'une quelconque des revendications précédentes, **caractérisé en ce qu'**une extrémité (1.25) de la carte de circuit imprimé (1.2) est disposée radialement à l'extérieur ou radialement à l'intérieur de la ligne circulaire.

9. Elément de balayage (1) selon l'une quelconque des revendications précédentes, **caractérisé en ce que** la carte de circuit imprimé (1.2) est disposée de manière à ce qu'une demi-droite (R) orientée radialement en partant de l'axe (A) coupe la carte de circuit imprimé (1.2) en au moins deux points (P).

10. Elément de balayage (1) selon la revendication 9, **caractérisé en ce que** la carte de circuit imprimé (1.2) est reliée par une extrémité (1.25) à un circuit imprimé (1.3) sur lequel est monté le circuit électronique (1.31), dans lequel la demi-droite (R) coupe également le circuit imprimé (1.3).

11. Elément de balayage (1) selon l'une quelconque des revendications précédentes, **caractérisé en ce que** la carte de circuit imprimé (1.2) est conçue à ses extrémités (1.24, 1.25) de manière à ce que les deux extrémités (1.24, 1.25) puissent être disposées en direction axiale afin qu'elles se chevauchent.

12. Elément de balayage (1) selon l'une quelconque des revendications précédentes, **caractérisé en ce que** la carte de circuit imprimé (1.2) est réalisée en plusieurs parties et **en ce que** les parties de la carte de circuit imprimé (1.2) sont reliées les unes aux autres par une pièce de pontage (1.26).

13. Elément de balayage (1) selon la revendication 12, **caractérisé en ce que** la pièce de pontage (1.26) présente, dans une direction parallèle à l'axe (A), une plus faible extension que la carte de circuit imprimé (1.2).

14. Elément de balayage (1) selon l'une quelconque des revendications précédentes, **caractérisé en ce que** la carte de circuit imprimé (1.2) est réalisée en plusieurs parties et **en ce que** les parties de la carte de circuit imprimé (1.2) sont disposées de manière espacée l'une de l'autre d'un interstice (u) en direction circonférentielle.

15. Elément de balayage (1) selon l'une quelconque des revendications précédentes, **caractérisé en ce que** le boîtier (1.1) comporte une partie de boîtier (1.11) qui est fixée au boîtier (1.1) à l'aide d'une contre-dépouille (1.151) s'étendant dans une direction parallèle à l'axe (A).
